# EUROPÄISCHE PATENTSCHRIFT

(11) **EP 1 425 167 B1**
(45) Veröffentlichungstag und Bekanntmachung des Hinweises auf die Patenterteilung: **19.11.2008**
(21) Anmeldenummer: 02769946.1
(22) Anmeldetag: 13.09.2002
(51) Int. Cl.: B32B 18/00, C04B 37/00, C04B 35/64

(54) **VERFAHREN ZUR HERSTELLUNG EINES KERAMISCHEN SUBSTRATS UND KERAMISCHES SUBSTRAT**
METHOD FOR PRODUCING A CERAMIC SUBSTRATE AND CERAMIC SUBSTRATE
PROCEDE DE FABRICATION D'UN SUBSTRAT CERAMIQUE ET SUBSTRAT CERAMIQUE

(30) Priorität: 14.09.2001 DE 10145363
(43) Veröffentlichungstag der Anmeldung: 09.06.2004
(73) Patentinhaber: EPCOS AG, 81669 München (DE)
(72) Erfinder: HOFFMANN, Christian, A-8530 Deutschlandsberg (AT); AICHHOLZER, Klaus-Dieter, A-8530 Deutschlandsberg (AT)
(74) Vertreter: Epping - Hermann - Fischer
(86) Internationale Anmeldenummer: PCT/DE2002/003412
(87) Internationale Veröffentlichungsnummer: WO 2003/024711

(56) Entgegenhaltungen:
- DE-A- 19 643 148
- US-A- 5 171 645
- US-A- 5 866 245
- US-B1- 6 207 905

## Beschreibung

Die Erfindung betrifft ein Verfahren zur Herstellung eines keramischen Substrats, wobei ein Grundkörper bereitgestellt wird, der einen Stapel von übereinanderliegenden Schichten aufweist. Die Schichten des Stapels enthalten ein ungesintertes Keramikmaterial. In einem darauffolgenden Schritt wird der Stapel gesintert.

Verfahren der eingangs genannten Art werden verwendet zur Herstellung von keramischen Vielschichtsubstraten, in das passive Bauelemente integriert werden können. Auf der Oberfläche des Substrats können mittels Verbindungstechnologien, wie SMD, Wire-Bonding oder auch Flip-Chip-Montage aktive Bauelemente montiert werden. Dadurch entstehen aus den keramischen Substraten multifunktionale Module, die insbesondere geeignet sind, Platz einzusparen.

Aus der Druckschrift US 6,207,905 ist ein Verfahren der eingangs genannten Art bekannt, wobei die übereinanderliegenden Schichten ein Keramikmaterial und Glas enthalten. Dabei beträgt der Gewichtsanteil von Glas und Keramikmaterial jeweils zirka 50 %. Das Glas dient dabei als Sinterhilfsmittel und ist in dem bekannten Verfahren derart beschaffen, daß es im Verlauf des Sinterprozesses rekristallisiert (Reaktionssintern). Aufgrund des Glasanteils von zirka 50 Gew.-% resultieren bei dem bekannten Verfahren zwischen den einzelnen Lagen des Vielschichtaufbaus Reaktionsschichten, die nur wenige Mikrometer dick sind. Bei der Montage von Bauelementen auf der Oberfläche des gesinterten Schichtstapels kann es bei Scherbeanspruchung zum Bruch in der obersten der Reaktionsschichten kommen, was dazu führt, daß Teile der obersten Schicht des Schichtstapels ausgerissen werden. Dieses Problem tritt verstärkt auf, wenn die oberste Schicht des Schichtstapels zum Beispiel mit einem organischen Material ganzflächig abgedeckt wird und auf diese Schicht eine Scherbeanspruchung wirkt.

In der Druckschrift US 5,866,245 wird ein Verfahren zur Herstellung eines gesinterten Siliziumnitrid-Körpers mit Schichten verschiedener Dichte und Porosität offenbart.

In der Druckschrift DE 196 43 148 A1 werden keramische Körper mit Mikrostruktur offenbart, die Bereiche mit gegenüber übrigen Bereichen erhöhter Dichte aufweisen.

Ziel der vorliegenden Erfindung ist es daher, ein Verfahren zur Herstellung eines keramischen Substrats anzugeben, das es erlaubt, die mechanische Anbindung der Schichten des Schichtstapels untereinander zu verbessern.

Dieses Ziel wird durch ein Verfahren nach Patentanspruch 1 erreicht. Vorteilhafte Ausgestaltungen des Verfahrens sowie ein keramisches Substrat sind den weiteren Ansprüchen zu entnehmen.

Die Erfindung gibt ein Verfahren zur Herstellung eines Keramiksubstrats an, wobei in einem ersten Schritt ein Grundkörper mit einem Stapel von übereinanderliegenden Schichten bereitgestellt wird. Die übereinanderliegenden Schichten enthalten ein ungesintertes Keramikmaterial und ein Sinterhilfsmittel.

Eine der Schichten des Schichtstapels weist gegenüber einer ihr benachbarten Schicht einen erhöhten Anteil an Sinterhilfsmittel auf.

In einem darauffolgenden Schritt wird der Schichtstapel gesintert, wodurch ein monolithischer Sinterkörper entsteht, der wenigstens eine wesentliche Komponente des herzustellenden Keramiksubstrats darstellt.

Das Sinterhilfsmittel beziehungsweise das Keramikmaterial in den Schichten des Schichtstapels ist so gewählt, daß zwischen der Schicht mit dem erhöhten Gewichtsanteil an Sinterhilfsmittel und der benachbarten Schicht mit einem geringeren Gewichtsanteil an Sinterhilfsmittel während des Sinterns eine Reaktionsschicht entsteht, welche die Haftung zwischen den keramischen Schicht vermittelt.

Das erfindungsgemäße Verfahren hat den Vorteil, daß durch den erhöhten Anteil an Sinterhilfsmittel in einer der Schichten der Austausch von Sinterhilfsmittel zwischen den Schichten des Schichtstapels verstärkt wird. Der Grund dafür ist das Konzentrationsgefälle an Sinterhilfsmittel zwischen den Schichten. Der Austausch von Sinterhilfsmittel zwischen den Schichten des Schichtstapels kann durch Diffusion geschehen, wobei die Diffusion durch den Konzentrationsunterschied an Sinterhilfsmittel zwischen den Schichten angetrieben wird. Der vermehrte Austausch von Sinterhilfsmittel zwischen den Schichten des Schichtstapels führt zu einer verbesserten Anbindung zwischen der Schicht, die den erhöhten Anteil an Sinterhilfsmittel enthält, und der dieser Schicht benachbarten Schicht durch die Ausbildung der Reaktionsschicht.

Eine solche Reaktionsschicht enthält das Sinterhilfsmittel aus der Schicht mit dem erhöhten Anteil an Sinterhilfsmittel und das Keramikmaterial aus der zu dieser Schicht benachbarten Schicht. Die Reaktionsschicht entsteht innerhalb der Schicht mit dem geringeren Anteil an Sinterhilfsmittel.

In einer vorteilhaften Ausführungsform der Erfindung wird ein Sinterhilfsmittel verwendet, das nach dem Sintern in einer anderen chemischen Zusammensetzung vorliegt als vor dem Sintern. Solche Sinterhilfsmittel sind zum Beispiel Sinterhilfsmittel, die für Reaktionssintern geeignet sind. Ein Beispiel für ein solches Sinterhilfsmittel ist ein Glas, das SiO₂ und Kalzium enthält. Ein solches Glas kann bei einer Temperatur von 900°C mit dem Keramikmaterial Al₂O₃ eine chemische Verbindung namens Anorthit (CaAl₂Si₂O₈) bilden. Desweiteren ist es charakteristisch für Reaktionssintern, daß das Sinterhilfsmittel bereits bei Temperaturen, die kleiner sind als die Sintertemperatur, fließfähig wird. Dadurch kann das Sinterhilfsmittel während des Sinterns wandern und sich innerhalb des Grundkörpers verteilen. Insbesondere kann das Sinterhilfsmittel von der Schicht mit erhöhtem Anteil an Sinterhilfsmittel zur benachbarten Schicht mit geringerem Anteil an Sinterhilfsmittel wandern.

Es ist desweiteren vorteilhaft, wenn die Schicht mit dem erhöhten Anteil an Sinterhilfsmittel die oberste Schicht des Schichtstapels ist. In diesem Fall kann nämlich die Anbindung der obersten Schicht des Schichtstapels an die darunterliegenden Schichten verbessert werden, wodurch die Empfindlichkeit des mit dem Verfahren hergestellten Keramiksubstrates gegenüber einer Scherbeanspruchung der Oberfläche des Keramiksubstrats, wie sie beispielsweise beim Auflöten von Bauelementen auf der Oberfläche des Substrats entstehen, vermindert wird.

Insbesondere kann das Sinterhilfsmittel beziehungsweise der erhöhte Gewichtsanteil an Sinterhilfsmittel so gewählt werden, daß eine Reaktionsschicht entsteht, die eine Dicke zwischen 5 und 100 µm aufweist. Eine solche Reaktionsschicht zwischen zwei Schichten des Schichtstapels ist wesentlich dicker als die Dicke der Reaktionsschichten, wie sie bei den bekannten Verfahren zur Herstellung von Keramiksubstraten entstehen. Die mit dem erfindungsgemäßen Verfahren hergestellten Reaktionsschichten vermitteln deshalb eine wesentlich stärkere Haftung zwischen zwei Keramikschichten.

Es ist darüber hinaus vorteilhaft, wenn bei dem erfindungsgemäßen Verfahren zur Aktivierung des erhöhten Glasanteils ein modifiziertes Entbinderungs- und Sinterprofil angewendet wird. Bei einem modifizierten Sinterprofil wird bei einer Temperatur oberhalb der Erweichungstemperatur des Sinterhilfsmittels eine zusätzliche Haltezeit eingefügt, die der erhöhten Menge an Sinterhilfsmittel ausreichend Zeit zum diffundieren läßt.

Die Schicht mit dem erhöhten Anteil an Sinterhilfsmittel kann beispielsweise einen Anteil an Sinterhilfsmittel zwischen 60 und 90 Gew.-% enthalten.

In einem weiteren Schritt zur Herstellung des Keramiksubstrats kann im Anschluß an das Sintern eine sinterhilfsmittelhaltige Metallpaste auf der Oberfläche der obersten Schicht des Schichtstapels aufgetragen und eingebrannt werden. Das Einbrennen der Metallpaste kann bei Temperaturen oberhalb von 600°C vorgenommen werden. Durch den erhöhten Anteil an Sinterhilfsmittel an der obersten Keramikschicht bildet sich während des Sinterns eine chemische Verbindung zwischen dem Keramikmaterial und dem Sinterhilfsmittel, die von der chemischen Verbindung abweicht, die entsteht, wenn der Keramikanteil und der Glasanteil gewichtsmäßig etwa gleich sind. Diese davon abweichende Verbindung hat die Eigenschaft, daß sie durch den erhöhten Glasanteil weniger spröde ist. Eine solche Verbindung in der obersten Schicht des Schichtstapels wird durch aus der Metallpaste in diese oberste Schicht eindringendes Glas weit weniger geschädigt, als eine Verbindung aus Sinterhilfsmittel und Keramikmaterial, die bei etwa gleichen Gewichtsverhältnissen der beiden Bestandteile gebildet ist. Demnach hat für den Fall von durch Metallpaste auf der Oberfläche des Keramiksubstrats gebildeten Kontaktflächen das erfindungsgemäße Verfahren den Vorteil, daß diese Kontaktflächen besser auf der obersten Schicht des Keramiksubstrats haften und nicht so leicht bei der Montage von Bauelementen ausgerissen werden können.

Eine solche Metallpaste kann neben Glas noch 70 - 90 Gew.-% Metall sowie geeignete organische Binde- und Lösungsmittel enthalten.

In einer weiteren vorteilhaften Ausführungsform der Erfindung wird vor dem Sintern eine Zwangsschicht auf der obersten Schicht des Schichtstapels angeordnet, welche durch Eindringen des Sinterhilfsmittels der obersten Schicht des Schichtstapels in die Zwangsschicht während des Sinterns auf dem Schichtstapel befestigt wird. Nach dem Sintern wird die Zwangsschicht wieder entfernt. Das Entfernen der Zwangsschicht kann beispielsweise durch Abkratzen oder auch Absputtern erfolgen.

Das Vorsehen einer Zwangsschicht während des Sinterns des Schichtstapels hat den Vorteil, daß das Schrumpfen des Schichtstapels in lateraler Richtung zu den Schichten, die den Schichtstapel bilden, reduziert werden kann. Die Zwangsschicht sorgt dafür, daß der Schichtstapel in lateraler Richtung nur sehr wenig schrumpft.

Als Zwangsschicht kommt beispielsweise eine starre Zwangsschicht in Form einer gesinterten Al₂O₃-Platte oder auch eine flexible Zwangsschicht in Form einer Grünfolie in Betracht, die selbst kein Sinterhilfsmittel enthält und die folglich auch während des Sinterns des Schichtstapels nicht mitsintert. Eine solche flexible Zwangsschicht ist beispielsweise bekannt aus der Druckschrift DE 691 06 830 T2.

Durch einen erhöhten Anteil an Sinterhilfsmittel in der obersten Schicht des Schichtstapels kann erreicht werden, daß das Sinterhilfsmittel in die Zwangsschicht über eine Tiefe > 50 µm eindringt. Die Eindringtiefe des Sinterhilfsmittels in die Zwangsschicht wäre demnach größer als 50 µm. Der schrumpfungshemmende Effekt im Falle der flexiblen Zwangsschicht rührt im wesentlichen davon her, daß eine ungesinterte, dichte Pulverschüttung auf der Oberseite des Schichtstapels aufliegt. Je nach Eindringtiefe des Sinterhilfsmittels in die Zwangsschicht muß also die Zwangsschicht mindestens so dick gemacht werden, daß wenigstens ein Teil der Zwangsschicht (eine Dicke von zirka 100 µm) nicht mit dem Sinterhilfsmittel in Berührung kommt und demnach auch nicht sintert. Nur durch das Nichtsintern von Teilen der Zwangsschicht kann das Schrumpfen des Schichtstapels während des Sinterns vermindert werden.

Die Zwangsschicht kann im Fall einer flexiblen Zwangsschicht beispielsweise eine Dicke > 150 µm aufweisen.

Die oberste Schicht des Schichtstapels kann ein Sinterhilfsmittel enthalten, das während des Sinterns fließfähig wird. Dadurch kann während des Sinterns die Befestigung der Zwangsschicht auf der obersten Schicht erfolgen.

In einer vorteilhaften Ausführungsform der Erfindung kann die Zwangsschicht Poren aufweisen, in die das Sinterhilfsmittel während des Sinterns eindringt. Da das Sinterhilfsmittel während des Sinterns fließfähig wird, kann es in die Poren der Zwangsschicht eindringen. Geeignete Poren der Zwangsschicht hätten eine Ausdehnung von 5 bis 10 µm, wobei eine geeignete Ausdehnung der Poren auch von der Viskosität des Sinterhilfsmittels während des Sinterns abhängt. In einer beispielhaften Ausführungsform der Erfindung kann als Sinterhilfsmittel ein Glas verwendet werden, das SiO₂ und Kalzium enthält.

Die chemische Reaktion zwischen dem Sinterhilfsmittel und der Zwangsschicht kann beispielsweise durch Sintern (Reaktionssintern) erfolgen. Es kann insbesondere eine flexible Zwangsschicht verwendet werden, wie sie aus der genannten Entgegenhaltung bekannt ist. Eine solche Zwangsschicht wird in Form einer keramischen Grünfolie auf die Oberseite des Schichtstapels aufgetragen, wobei die Grünfolie jedoch von Sinterhilfsmittel frei ist. Dadurch wird gewährleistet, daß die Zwangsschicht wenigstens teilweise nicht während Sinterns des Schichtstapels mitgesintert wird.

Eine flexible Zwangsschicht kann beispielsweise eine Grünfolie sein, die Al₂O₃-Körner und ein polymeres Bindemittel enthält.

In einer weiteren vorteilhaften Ausführungsform der Erfindung wird die Zwangsschicht und das Sinterhilfsmittel so gewählt, daß das Sinterhilfsmittel während des Sinterns mit Bestandteilen der Zwangsschicht chemisch reagiert.

Für eine solche chemische Reaktion kann beispielsweise als starre Zwangsschicht eine keramische Platte verwendet werden, die Al₂O₃ enthält. Als Sinterhilfsmittel in der obersten Schicht des Schichtstapels kann ein Glas verwendet werden, das SiO₂ und Kalzium enthält. Ein solches Glas kann bei einer Temperatur von 900°C mit dem Al₂O₃ der Zwangsschicht eine chemische Verbindung namens Anorthit (CaAl₂Si₂O₈) bilden. Dadurch entsteht zwischen der obersten Schicht des Schichtstapels und der Zwangsschicht eine Reaktionsschicht, die eine feste Anbindung der Zwangsschicht an die obersten Schicht des Schichtstapels bewerkstelligt.

Insbesondere kann als starre Zwangsschicht eine keramische Platte verwendet werden, die Al₂O₃ enthält und die frei von Sinterhilfsmitteln ist. Eine solche keramische Platte kann durch Sintern bei Temperaturen von 1500°C hergestellt werden. Diese hohe Sintertemperatur stellt sicher, daß die Zwangsschicht während des Sinterns des Schichtstapels bei Temperaturen > 1000°C keiner Schrumpfung mehr unterliegt.

Daneben ist es vorteilhaft, wenn das Eindringen des Sinterhilfsmittels in Poren der Zwangsschicht und die chemische Reaktion des Sinterhilfsmittels mit Bestandteilen der Zwangsschicht durch entsprechende Materialauswahl miteinander kombiniert wird. Dadurch wird eine besonders feste Anbindung der Zwangsschicht an die oberste Schicht des Schichtstapels bewerkstelligt.

In einer vorteilhaften Ausführungsform der Erfindung kann eine starre Zwangsschicht verwendet werden, die eine Dicke zwischen 0,5 mm und 1,5 mm aufweist. Die Zwangsschicht muß dabei eine gewisse Mindestdicke aufweisen, um insbesondere für großflächige Sinterkörper eine ausreichende mechanische Stabilität aufzuweisen. Darüber hinaus darf die Zwangsschicht aber nicht zu dick sein, da ansonsten das Entfernen der Zwangsschicht zu aufwendig wird.

Die Zwangsschicht kann beispielsweise Körner aus Al₂O₃ enthalten, die miteinander versintert sind.

Die Schichten des Schichtstapels können als keramische Feststoff-Komponente Bariumtitanat, Kalziumtitanat, Strontiumtitanat, Bleititanat, CaZrO₃, BaZrO₃, BaSnO₃, Metallcarbide wie Siliziumcarbid, Metallnitride wie Aluminiumnitrid, Mineralien wie Molit und Kyanit, Zirkoniumdioxid oder auch verschiedene Arten von Siliziumdioxid enthalten. Selbst Gläser mit hohem Erweichungspunkt können als die keramische Komponente verwendet werden, vorausgesetzt, daß sie ausreichend hohe Erweichungspunkte haben. Weiterhin können Mischungen derartiger Materialien für die keramische Feststoff-Komponente der Schichten des Schichtstapels verwendet werden.

Die Verwendung des erfindungsgemäßen Verfahrens zur Herstellung von keramischen Substraten ermöglicht insbesondere die Verwendung von Schichtstapeln, die die Form einer Platte aufweisen, wobei die Platte eine Grundfläche von wenigstens 18 cm x 18 cm und eine Höhe von 0,5 bis 3 mm aufweist. Mittels einer solchen Platte können in einem einzigen Herstellungsschritt ein großflächiges, oder durch nachfolgendes Zerteilen des großflächigen Substrates, eine Vielzahl von kleinen Substraten hergestellt werden.

Es ist darüber hinaus besonders vorteilhaft, wenn das Sintern des Schichtstapels bei einer Temperatur von weniger als 1000°C erfolgt, da in diesem Fall ein LTCC-Sinterprozeß vorliegt, der die Verwendung von Silber-Verbindungen für Leiterstrukturen im Innern des Substrats ermöglicht, was zu niedrigeren Verlusten innerhalb des Bauelements führt. Die Verwendung von Silber hat darüber hinaus den Vorteil, daß es im Gegensatz zu den bei höheren Sintertemperaturen erforderlichen Platin leichter und billiger verfügbar ist.

Es ist desweiteren vorteilhaft, wenn zusätzlich zur Oberseite des Schichtstapels auch auf der Unterseite des Schichtstapels eine Zwangsschicht auf der Oberfläche der untersten Schicht des Schichtstapels angeordnet wird. Dadurch kann das Schrumpfen der Schichten des Schichtstapels von zwei Seiten her vermindert werden, was insgesamt eine noch geringere Schrumpfung zur Folge hat.

Es kommt insbesondere in Betracht, als Stapel einen Schichtstapel zu verwenden, bei dem zwischen zwei Schichten Leiterbahnen angeordnet sind. Diese Leiterbahnen können verwendet werden zur Herstellung einer Verdrahtung zwischen auf der Oberfläche des Keramiksubstrats angeordneten aktiven Bauelementen und im Innern des Keramiksubstrats angeordneten passiven Bauelementen. Die Leiterbahnen beziehungsweise elektrisch leitenden Flächen zwischen zwei Schichten des Schichtstapels können auch dazu verwendet werden, passive Bauelemente, beispielsweise Kondensatoren oder Spulen zu realisieren.

Um die zwischen den Schichten angeordneten Leiterbahnen miteinander zu kontaktieren, ist es vorteilhaft, wenn eine Schicht im Stapel eine Durchführung enthält, die elektrisch leitfähig ist und die auf zwei verschiedenen Seiten der Schicht angeordnete Leiterbahnen miteinander verbindet.

Desweiteren gibt die Erfindung ein Keramiksubstrat an, das einen Stapel aus übereinanderliegenden Schichten enthält. Die übereinanderliegenden Schichten des Schichtstapels enthalten ein Keramikmaterial und sind miteinander versintert. Sie enthalten ferner Reste eines Sinterhilfsmittels, die nicht durch Reaktionssintern in eine andere Verbindung umgeformt worden sind. Eine der Schichten des Schichtstapels enthält einen höheren Anteil an Resten eines Sinterhilfsmittels als die zu dieser Schicht benachbarte Schicht. Ein solches Keramiksubstrat kann durch erfindungsgemäße Verfahren hergestellt werden. Durch den erhöhten Anteil an Sinterhilfsmittel vor dem Sintern erhält die Schicht auch einen erhöhten Restanteil an Sinterhilfsmittel. Der Anteil an unveränderten Resten von Sinterhilfsmittel kann zwischen 5 und 30 Gew.-% betragen.

Zwischen der Schicht mit dem erhöhten Anteil an unveränderten Resten von Sinterhilfsmittel und der benachbarten Schicht ist eine Reaktionsschicht angeordnet, die Sinterhilfsmittel von der Schicht mit dem hohen Anteil an unveränderten Resten eines Sinterhilfsmittels enthält. Daneben enthält die Reaktionsschicht Keramikmaterial und Sinterhilfsmittel von der benachbarten Schicht. Die Reaktionsschicht kann eine Dicke zwischen 10 und 50 µm aufweisen. Damit ist die Reaktionsschicht wesentlich dicker als die Reaktionsschichten, die nach dem bekannten Verfahren hergestellt werden.

Im folgenden wird die Erfindung anhand von Ausführungsbeispielen und den dazugehörigen Figuren näher erläutert.
- Figur 1: zeigt beispielhaft ein keramisches Substrat während seiner Herstellung nach dem erfindungsgemäßen Verfahren in einem schematischen Querschnitt.
- Figur 2: zeigt beispielhaft ein keramisches Substrat, das nach dem erfindungsgemäßen Verfahren hergestellt worden ist mit einer Metallpaste auf der Oberfläche.
- Figur 3: zeigt beispielhaft ein keramisches Substrat während seiner Herstellung nach dem erfindungsgemäßen Verfahren in einem schematischen Querschnitt.
- Figur 4: zeigt ein beispielhaft ein erfindungsgemäßes LTCC-Substrat in einem schematischen Querschnitt, hergestellt mit dem erfindungsgemäßen Verfahren.

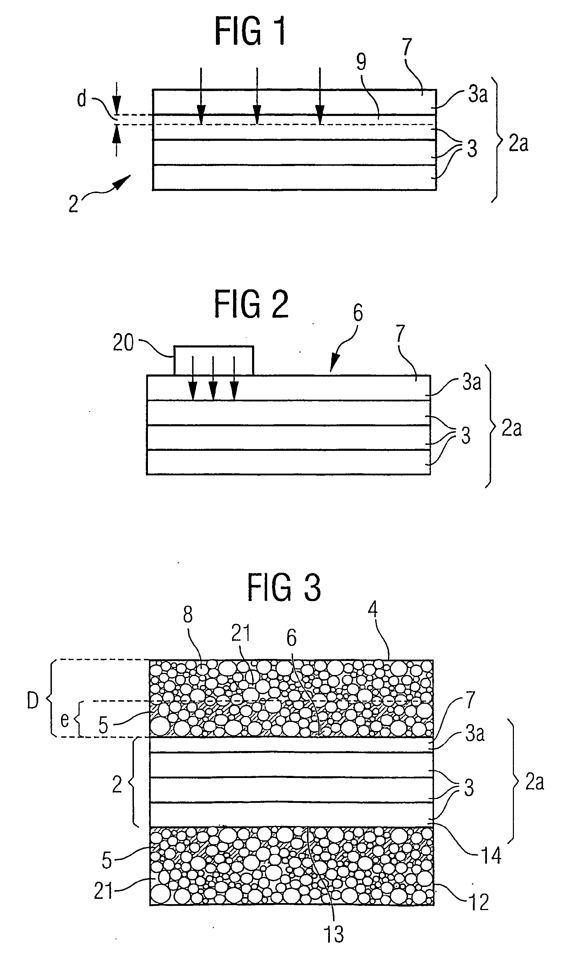

Figur 1 zeigt einen Grundkörper 2 mit einem Stapel 2a von übereinanderliegenden Schichten 3. Die Schichten 3 enthalten ein ungesintertes Keramikmaterial. Im allgemeinen enthalten die Schichten 3 des Schichtstapels 2a neben dem Keramikmaterial und dem Sinterhilfsmittel noch ein Bindemittel, das den Schichten 3, die üblicherweise als Grünfolien vorliegen, die zur Verarbeitung notwendige Geschmeidigkeit verleiht. Das Bindemittel, das beispielsweise ein polymeres Bindemittel sein kann, wird mittels Binderausbrand noch vor dem Sintern des Schichtstapels aus diesem entfernt. Die oberste Schicht 7 des Schichtstapels 2a ist eine Schicht 3a mit erhöhtem Anteil an Sinterhilfsmittel. Das Sinterhilfsmittel aus der Schicht 3a kann, wie durch die Pfeile angedeutet, in die darunterliegende Schicht 3 diffundieren und dort eine Reaktionsschicht 9 bilden. Die Dicke d der Reaktionsschicht 9 kann beispielsweise 10 bis 50 µm betragen. Die Dicke d der Reaktionsschicht 9 kann eingestellt werden durch den Überschuß an Sinterhilfsmittel in der Schicht 3a. Je dicker die Reaktionsschicht 9 ist, um so besser ist die mechanische Anbindung der obersten Schicht 7 des Schichtstapels 2a an die darunterliegende Schicht 3.

Figur 2 zeigt einen Schichtstapel 2a mit übereinanderliegenden Schichten 3, wobei die oberste Schicht 7 des Schichtstapels 2a eine Schicht mit erhöhtem Anteil an Sinterhilfsmittel ist. Für die Figuren 1 und 2 gilt, daß der Gewichtsanteil von Sinterhilfsmittel in der Schicht 3a 70 % beträgt. Darüber hinaus enthält die Schicht 3a noch Al₂O₃ als Keramikmaterial. Auf der Oberfläche 6 der obersten Schicht 7 ist eine Metallpaste 20 aufgetragen, mit deren Hilfe eine Kontaktfläche auf der Oberseite des Schichtstapels 2a realisiert werden soll. Die Metallpaste 20 enthält ein Metallpulver und einen Glasanteil. Der Glasanteil kann dabei dasselbe Sinterhilfsmittel sein, wie es in den Schichten 3 des Schichtstapels 2a verwendet wird und er kann insbesondere auch dasselbe Sinterhilfsmittel sein, wie es in der Schicht 3a mit erhöhtem Anteil an Sinterhilfsmittel Verwendung findet. Es können aber auch für die einzelnen Schichten 3 des Schichtstapels 2a oder auch nur für die Schicht 3a mit erhöhtem Anteil an Sinterhilfsmittel jeweils ein unterschiedliches Sinterhilfsmittel, beispielsweise bei verschiedenen Temperaturen schmelzende Gläser, verwendet werden.

Die Metallpaste 20 wird auf der Oberfläche 6 der obersten Schicht 7 eingebrannt. Während des Einbrennens diffundiert ein Teil des Glasanteils der Metallpaste 20, der etwa 2 Gew.-% beträgt, in die oberste Schicht 7 des Schichtstapels (vgl. die Pfeile). Als Sinterhilfsmittel wird in den Figuren 1 und 2 jeweils Glas mit einem Anteil an Kalzium verwendet. Aufgrund des erhöhten Glasanteils der Schicht 3a des Schichtstapels 2a hat das aus der Metallpaste 20 in die oberste Schicht 7 eindringende Glas nur noch einen sehr geringen Effekt, wodurch nur eine sehr geringe Veränderung der chemischen Zusammensetzung der gesinterten Schicht 3a erfolgt. Daraus resultiert eine erhöhte Festigkeit der Anbindung der Metallpaste 20 an die oberste Schicht 7 des Schichtstapels 2a. Dadurch wird die mechanische Festigkeit erhöht und die Gefahr des Ausreißens von Metallflächen auf der Oberseite des Schichtstapels während des Anlötens von Bauelementen wird dadurch reduziert.

Figur 3 zeigt einen Grundkörper 2 mit einem Stapel 2a von übereinanderliegenden Schichten 3. Die Schichten 3 enthalten ein ungesintertes Keramikmaterial. Im allgemeinen enthalten die Schichten 3 des Schichtstapels 2a neben dem Keramikmaterial und dem Sinterhilfsmittel 5 noch ein Bindemittel, das den Schichten 3, die üblicherweise als Grünfolien (englisch: Green Tapes) vorliegen, die zur Verarbeitung notwendige Geschmeidigkeit verleiht. Die Oberfläche 13 der untersten Schicht 14 des Stapels 2a liegt direkt auf der zweiten starren Zwangsschicht 12 auf. Auf der Oberfläche 6 der obersten Schicht 7 des Stapels 2a liegt direkt die Zwangsschicht 4 auf. Die oberste Schicht 7 des Stapels ist eine Schicht 3a mit erhöhtem Anteil an Sinterhilfsmittel. Die Zwangsschichten 4, 12 enthalten Körner 8 aus Al₂O₃ und weisen Poren 21 auf. Diese Poren 21 bilden Hohlräume, in die das Sinterhilfsmittel 5, das aus der obersten Schicht 7 beziehungsweise aus der untersten Schicht 14 des Schichtstapels 2a stammt, eindringen kann. Durch das in die Poren 21 eindringende Sinterhilfsmittel 5 wird eine Haftung der jeweiligen Zwangsschicht 4, 12 an dem Schichtstapel 2a vermittelt. Das Anbringen der Zwangsschichten 4, 12 an den Schichtstapel 2a kann vor oder auch nach dem Entbindern des Schichtstapels 2a erfolgen. In Richtung der Ausdehnung der Schichten 3 in lateraler Richtung des Stapels 2a kann somit das Schrumpfen während des Sinterns wirksam vermindert werden. Das Festhalten des Schichtstapels 2a in lateraler Richtung bewirkt, daß das Schrumpfen fast ausschließlich in vertikaler Richtung, also senkrecht zu den Flachseiten der Schichten 3 stattfindet. Dieser sogenannte "Schrumpf in z-Richtung" ist dabei um so stärker.

Das Sinterhilfsmittel 5 dringt dabei über eine Eindringtiefe e in die Zwangsschicht 4 ein. Es muß darauf geachtet werden, daß das Sinterhilfsmittel 5 nicht über die gesamte Dicke D der Zwangsschicht 4 sondern nur über einen Teil derselben eindringt. Im Falle einer flexiblen Zwangsschicht beispielsweise ist dies besonders wichtig. Die Eindringtiefe e kann dabei jedoch wesentlich größer als 50 µm sein. Entsprechend muß die Dicke D der Zwangsschicht 4 größer sein als die Eindringtiefe e des Sinterhilfsmittels 5 in die Poren 21 der Zwangsschicht 4.

Entsprechend kann auch auf der unteren Oberfläche 13 der untersten Schicht 4 eine flexible Zwangsschicht 12 angeordnet sein. Auch die unterste Schicht 14 des Schichtstapels 2a kann eine Schicht mit erhöhtem Anteil an Sinterhilfsmittel 5 sein, wobei entsprechend der weiter oben beschriebenen Art und Weise auch hier das Eindringen des Sinterhilfsmittel 5 in die Poren 21 der Zwangsschicht 12 beachtet werden muß.

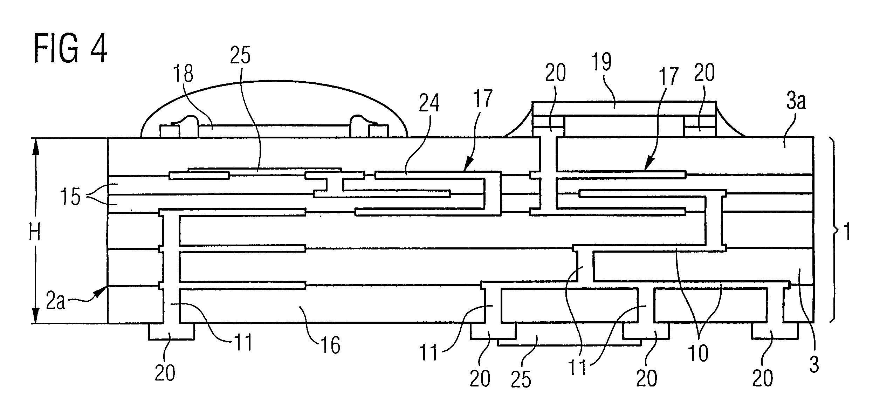

Figur 4 zeigt ein mit dem erfindungsgemäßen Verfahren fertig hergestelltes keramisches Substrat 1, bei dem die Zwangsschichten bereits entfernt worden sind. Das Substrat 1 ist hergestellt aus einem Stapel 2a von übereinanderliegenden Schichten 3, die ein ungesintertes Keramikmaterial enthalten, wobei das ungesinterte Keramikmaterial durch Sintern in ein gesintertes Keramikmaterial übergeführt worden ist. Auf der Oberseite der obersten Schicht 3a des keramischen Substrats 1 sind Bauelemente 18, 19 angeordnet, wobei das erste Bauelemente 18 durch Drahtbonden und anschließendes Vergießen und das zweite Bauelement 19 durch Flip-Chip-Montage auf der Oberfläche des keramischen Substrats 1 befestigt ist. Die beiden Bauelemente 18, 19 können beispielsweise keramische Mikrowellenfilter sein. Auf der Unterseite des keramischen Substrats 1 sind Metallisierungen aus Metallpaste 20 angeordnet, an denen das Substrat 1 auf eine Leiterplatte gelötet und mithin mit weiteren elektronischen Bauelementen elektrisch in Kontakt gebracht werden kann. Auch auf der Oberseite des Substrats 1 sind Metallisierungen aus Metallpaste 20 angeordnet, auf denen die Bauelemente 18, 19 befestigt werden können. Das Substrat 1 weist eine Höhe H von 1 mm auf.

Die Zahl der Schichten 3 beträgt sechs.

Im Innern des Substrats 1 befinden sich Verdrahtungsebenen, die durch Leiterbahnen 10 realisiert werden. Dabei befindet sich eine Verdrahtungsebene immer an der Grenzfläche zwischen zwei Schichten 3. Die Leiterbahnen 10 können beispielsweise durch eine silberhaltige Siebdruckpaste gebildet werden. Darüber hinaus weist eine Schicht 3 auch Durchführungen 11 auf, die auf zwei gegenüberliegenden Seiten der Schicht 3 liegende Leiterbahnen 10 miteinander kontaktiert. In den Durchführungen 11 sind elektrisch leitende Materialien angeordnet, die vorteilhafterweise die Durchführungen 11 auffüllen.

Im oberen Bereich des Substrats 1 sind zwei der Schichten 3 als Schichten 15 mit hohem ε ausgebildet. Ein solches ε kann beispielsweise ε = 20 sein. Durch entsprechend ausgebildete Leiterbahnen 10 beziehungsweise elektrisch leitende Flächen 24 in den Verdrahtungsebenen können passive Komponenten wie Kondensatoren 17 in das Substrat 1 integriert sein. Gemäß Figur 4 sind elektrisch leitende Flächen 24 an den Grenzschichten zwischen zwei Schichten 3 so angeordnet und durch Durchführungen 11 miteinander verbunden, daß ineinandergreifende Kammstrukturen, wie sie aus Vielschichtkondensatoren bekannt sind, entstehen. Durch das Aufdrucken einer Widerstandspaste 25 vor dem Verstapeln der Schichten 3 an der Grenzflächen zwischen den Schichten 3 können auch integrierte Widerstände als Passivkomponenten im Substrat 1 hergestellt werden. Durch Ausbilden von Leiterbahnen 10 in Form von spiralförmigen Bahnen und durch Aneinanderreihen von übereinander gestapelten spiralförmigen Bahnen können auch integrierte Spulen 16 in dem Substrat 1 hergestellt werden.

Die dargestellte Erfindung wird vorzugsweise für Stapel 2a verwendet, die aus im wesentlichen entlang von Ebenen verlaufenden Schichten 3 hergestellt sind. Es ist jedoch auch denkbar, die Erfindung auf gekrümmte Substrate anzuwenden, wobei die Schichten 3 dann nicht entlang einer Ebene sondern entlang von gekrümmten Kurven verlaufen.

## Patentansprüche

1. Verfahren zur Herstellung eines keramischen Substrats (1) mit folgenden Schritten:
a) Bereitstellen eines Grundkörpers (2) mit einem Stapel (2a) von übereinanderliegenden Schichten (3), die ein ungesintertes Keramikmaterial und ein Sinterhilfsmittel (5) enthalten, wobei eine der Schichten (3a) einen gegenüber einer benachbarten Schicht (3) erhöhten Anteil an Sinterhilfsmittel (5) enthält,
b) Sintern des Schichtstapels (2a), wobei zwischen der Schicht (3a) mit dem erhöhten Anteil an Sinterhilfsmittel (5) und der benachbarten Schicht (3) während des Sinterns eine Reaktionsschicht (9) entsteht, welche die Haftung zwischen den keramischen Schichten (3, 3a) vermittelt.

2. Verfahren nach Anspruch 1,
wobei das Sinterhilfsmittel (5) nach dem Sintern in einer anderen chemischen Zusammensetzung vorliegt als vor dem Sintern.

3. Verfahren nach einem der Ansprüche 1 oder 2,
wobei die oberste Schicht (7) des Schichtstapels (2a) einen gegenüber einer benachbarten Schicht (3) erhöhten Anteil an Sinterhilfsmittel (5) enthält.

4. Verfahren nach einem der Ansprüche 1 bis 3,
wobei die Dicke d der Reaktionsschicht (9) zwischen 5 und 100 µm beträgt.

5. Verfahren nach einem der Ansprüche 1 bis 4,
wobei zur Aktivierung des erhöhten Glasanteils ein Entbinderungs- und Sinterprofil angewandt wird, das oberhalb der Erweichungstemperatur des Glasanteils eine Haltezeit aufweist.

6. Verfahren nach einem der Ansprüche 1 bis 5,
wobei der Anteil an Sinterhilfsmittel (5) in der Schicht (3a) mit dem erhöhten Anteil an Sinterhilfsmittel (5) zwischen 60 und 90 Gew.-% beträgt.

7. Verfahren nach einem der Ansprüche 1 bis 6,
wobei im Anschluß an das Sintern eine sinterhilfsmittelhaltige Metallpaste (20) auf der Oberfläche (6) der obersten Schicht (7) des Stapels (2a) aufgetragen und eingebrannt wird.

8. Verfahren nach einem der Ansprüche 1 bis 7,
wobei vor dem Sintern eine Zwangsschicht (4) auf der obersten Schicht (7) des Schichtstapels (2a) angeordnet wird, die durch Eindringen des Sinterhilfsmittels (5) der obersten Schicht (7) in die Zwangsschicht (4) während des Sinterns auf dem Schichtstapel (2a) befestigt wird und die nach dem Sintern wieder entfernt wird.

9. Verfahren nach Anspruch 8,
wobei die Eindringtiefe (e) des Sinterhilfsmittels (5) in die Zwangsschicht (4) > 50 µm ist.

10. Verfahren nach einem der Ansprüche 8 oder 9,
wobei die Zwangsschicht (4) eine Dicke (D) aufweist, die um mindestens 100 µm größer ist als die Eindringtiefe (e).

11. Verfahren nach einem der Ansprüche 1 bis 10,
wobei das Sinterhilfsmittel (5) Glas enthält.

12. Verfahren nach einem der Ansprüche 1 bis 11,
wobei zur Bildung des Stapels (2a) Schichten (3, 3a) verwendet werden, die als Keramikmaterial Al₂O₃ und als Sinterhilfsmittel (5) Glas enthalten.

13. Verfahren nach einem der Ansprüche 1 bis 12,
wobei ein Stapel (2a) verwendet wird, der die Form einer Platte aufweist, wobei die Platte eine Grundfläche von wenigstens 18 cm x 18 cm und eine Höhe (H) von 0,5 bis 3 mm aufweist.

14. Verfahren nach einem der Ansprüche 8 bis 13,
wobei ein Stapel (2a) verwendet wird, bei dem zwischen zwei Schichten (3) Leiterbahnen (10) angeordnet sind.

15. Verfahren nach einem der Ansprüche 1 bis 14,
wobei eine zweite Zwangsschicht (12) auf der Oberfläche (13) der untersten Schicht (14) des Stapels (2a) angeordnet wird.

16. Keramisches Substrat aus einem Stapel (2a) von übereinanderliegenden Schichten (3, 3a), die ein Keramikmaterial enthalten und miteinander versintert sind und die unveränderte Reste eines Sinterhilfsmittels (5) enthalten, bei dem eine Schicht (3a) einen höheren Anteil an unverändertem Sinterhilfsmittel (5) enthält als die benachbarte Schicht (3), bei dem zwischen der Schicht (3a) mit dem erhöhten Anteil an unveränderten Sinterhilfsmittel (5) und der zu dieser Schicht (3a) benachbarten Schicht (3) eine Reaktionsschicht (9) angeordnet ist, die Sinterhilfsmittel (5) aus der Schicht (3a) und Keramikmaterial aus der dazu benachbarten Schicht (3) enthält,
wobei die Reaktionsschicht (9) die Haftung zwischen den keramischen Schichten (3, 3a) vermittelt.

17. Keramisches Substrat nach Anspruch 16,
bei dem der höhere Anteil an unverändertem Sinterhilfsmittel (5) 5 bis 30 Gew.-% beträgt.

18. Keramisches Substrat nach einem der Ansprüche 16 oder 17, bei dem die oberste Schicht (7) des Schichtstapels (2a) einen höheren Anteil an unverändertem Sinterhilfsmittel (5) enthält als die benachbarte Schicht (3).

19. Keramisches Substrat nach einem der Ansprüche 16 bis 18, bei demdie Dicke (d) der Reaktionsschicht (9) 10 bis 50 µm beträgt.

20. Keramisches Substrat nach Anspruch 18 oder 19,
bei dem auf der obersten Schicht (7) des Stapels (2a) eine Metallpaste (20) eingebrannt ist.

21. Keramisches Substrat nach einem der Ansprüche 16 bis 20, bei dem zwischen zwei Schichten (3) des Stapels (2a) Leiterbahnen (10) angeordnet sind.

22. Keramisches Substrat nach Anspruch 21,
bei dem eine Schicht (3) eine elektrisch leitfähige Durchführung (11) enthält, die zwei auf verschiedenen Seiten der Schicht (3) angeordnete Leiterbahnen (10) miteinander verbindet.

## Claims

1. Method for producing a ceramic substrate (1) comprising the following steps:
a) providing a basic body (2) comprising a stack (2a) of layers (3) which lie one above another and contain an unsintered ceramic material and a sintering auxiliary (5), wherein one of the layers (3a) contains an increased proportion of sintering auxiliary (5) relative to an adjacent layer (3),
b) sintering the layer stack (2a), wherein during the sintering a reaction layer (9) arises between the layer (3a) having the increased proportion of sintering auxiliary (5) and the adjacent layer (3), which reaction layer promotes the adhesion between the ceramic layers (3, 3a).

2. Method according to Claim 1,
wherein the sintering auxiliary (5) is present in a different chemical composition after the sintering from that before the sintering.

3. Method according to either of Claims 1 and 2,
wherein the topmost layer (7) of the layer stack (2a) contains an increased proportion of sintering auxiliary (5) relative to an adjacent layer (3).

4. Method according to any of Claims 1 to 3,
wherein the thickness d of the reaction layer (9) is between 5 and 100 µm

5. Method according to any of Claims 1 to 4,
wherein a binder removal and sintering profile having a hold time above the softening temperature of the glass proportion is employed for activating the increased glass proportion.

6. Method according to any of Claims 1 to 5,
wherein the proportion of sintering auxiliary (5) in the layer (3a) having the increased proportion of sintering auxiliary (5) is between 60 and 90% by weight.

7. Method according to any of Claims 1 to 6,
wherein after the sintering, a metal paste (20) containing sintering auxiliary is applied on the surface (6) of the topmost layer (7) of the stack (2a) and baked.

8. Method according to any of Claims 1 to 7,
wherein, before the sintering, a forcing layer (4) is arranged on the topmost layer (7) of the layer stack (2a), which is fixed on the layer stack (2a) during the sintering by penetration of the sintering auxiliary (5) of the topmost layer (7) into the forcing layer (4) and which is removed again after the sintering.

9. Method according to Claim 8,
wherein the penetration depth (e) of the sintering auxiliary (5) into the forcing layer (4) is > 50 µm.

10. Method according to either of Claims 8 and 9,
wherein the forcing layer (4) has a thickness (D) that is at least 100 µm greater than the penetration depth (e).

11. Method according to any of Claims 1 to 10,
wherein the sintering auxiliary (5) contains glass.

12. Method according to any of Claims 1 to 11,
wherein layers (3, 3a) containing Al₂O₃ as ceramic material and glass as sintering auxiliary (5) are used for forming the stack (2a).

13. Method according to any of Claims 1 to 12,
wherein a stack (2a) having the form of a plate is used, wherein the plate has a base area of at least 18 cm x 18 cm and a height (H) of 0.5 to 3 mm.

14. Method according to any of Claims 8 to 13,
wherein a stack (2a) is used in which conductor tracks (10) are arranged between two layers (3).

15. Method according to any of Claims 1 to 14,
wherein a second forcing layer (12) is arranged on the surface (13) of the bottommost layer (14) of the stack (2a).

16. Ceramic substrate composed of a stack (2a) of layers (3, 3a) which lie one above another, contain a ceramic material and are sintered together and contain unchanged residues of a sintering auxiliary (5), in which one layer (3a) contains a higher proportion of unchanged sintering auxiliary (5) than the adjacent layer (3), in which a reaction layer (9) is arranged between the layer (3a) having the increased proportion of unchanged sintering auxiliary (5) and the layer (3) adjacent to said layer (3a), which reaction layer contains sintering auxiliary (5) from the layer (3a) and ceramic material from the layer (3) adjacent thereto,
wherein the reaction layer (9) provides the adhesion between the ceramic layers (3, 3a).

17. Ceramic substrate according to Claim 16,
in which the higher proportion of unchanged sintering auxiliary (5) is 5 to 30% by weight.

18. Ceramic substrate according to either of Claims 16 and 17,
in which the topmost layer (7) of the layer stack (2a) contains a higher proportion of unchanged sintering auxiliary (5) than the adjacent layer (3).

19. Ceramic substrate according to any of Claims 16 to 18,
in which the thickness (d) of the reaction layer (9) is 10 to 50 µm.

20. Ceramic substrate according to Claim 18 or 19,
in which a metal paste (20) is baked on the topmost layer (7) of the stack (2a).

21. Ceramic substrate according to any of Claims 16 to 20,
in which conductor tracks (10) are arranged between two layers (3) of the stack (2a).

22. Ceramic substrate according to Claim 21,
in which a layer (3) contains an electrically conductive feedthrough (11) which connects two conductor tracks (10) arranged on different sides of the layer (3) to one another.

## Revendications

1. Procédé de production d'un substrat (1) en céramique ayant les stades suivants :
a) on prépare un corps (2) de base ayant une pile (2a) de couches (3) superposées qui contiennent un matériau céramique non-fritté et un adjuvant (3) de frittage, l'une des couches (3a) contenant une proportion d'adjuvant (5) de frittage accrue par rapport à une couche (3) voisine,
b) on fritte la pile (2a) de couches en créant entre la couche (3a) ayant la proportion accrue d'adjuvant (5) de frittage et la couche (3) voisine pendant le frittage une couche (9) de réaction, qui facilite l'adhérence entre les couches (3, 3a) de céramique.

2. Procédé selon la revendication 1,
dans lequel l'adjuvant (5) de frittage est présent après le frittage en une composition chimique autre qu'avant le frittage.

3. Procédé selon l'une des revendications 1 ou 2,
dans lequel la couche (7) la plus haute de la pile (2a) de couches a une proportion accrue d'adjuvant (5) de frittage par rapport à une couche (3) voisine.

4. Procédé selon l'une des revendications 1 à 3,
dans lequel l'épaisseur (d) de la couche (9) de réaction est comprise entre 5 et 100 µm.

5. Procédé selon l'une des revendications 1 à 4,
dans lequel pour l'activation de la proportion de verre accrue, on applique un profil d'élimination du liant et de frittage, qui a un temps de maintien au-dessus de la température de ramollissement de la proportion de verre.

6. Procédé selon l'une des revendications 1 à 5,
dans lequel une proportion de l'adjuvant (5) de frittage dans la couche (3) ayant la proportion accrue d'adjuvant (5) de frittage est comprise en 60 et 90 % en poids.

7. Procédé selon l'une des revendications 1 à 6,
dans lequel à la suite du frittage, on dépose une pâte (20) métallique contenant de l'adjuvant de frittage sur la surface (6) de la couche (7) la plus haute de la pile (2a) et on la cuit.

8. Procédé selon l'une des revendications 1 à 7,
dans lequel, avant le frittage, on met une couche (4) coercitive sur la couche (7) la plus haute de la pile (2a) de couches, couche coercitive qui, par pénétration de l'adjuvant (5) de frittage de la couche (7) la plus haute dans la couche (4) coercitive, est fixée pendant le frittage sur la pile (2) de couches et qui est éliminée à nouveau après le frittage.

9. Procédé selon la revendication 8,
dans lequel la profondeur (e) de pénétration de l'adjuvant (5) de frittage dans la couche (4) coercitive est supérieure à 50 µm.

10. Procédé selon l'une des revendications 8 ou 9,
dans lequel la couche (4) coercitive à une épaisseur (D) qui est plus grande d'au moins de 100 µm que la profondeur (e) de pénétration.

11. Procédé selon l'une des revendications 1 à 10,
dans lequel l'adjuvant (5) de frittage contient du verre.

12. Procédé selon l'une des revendications 1 à 11,
dans lequel, pour la formation de la pile (2a), on utilise des couches (3, 3a) qui contiennent comme matière céramique de l'Al₂0₃ et comme adjuvant (5) de frittage du verre.

13. Procédé selon l'une des revendications 1 à 12,
dans lequel on utilise une pile (2a) qui a la forme d'une plaque, la plaque ayant une surface de base d'au moins 18 cm x 18 cm et une hauteur (H) de 0,5 à 3 mm.

14. Procédé selon l'une des revendications 8 à 13,
dans lequel on utilise une pile (2a) dans laquelle deux des pistes (10) conductrices sont disposées entre deux couches (3).

15. Procédé selon l'une des revendications 1 à 14,
dans lequel on met une deuxième couche (12) coercitive sur la surface (13) de la couche (14) la plus basse de la pile (2a).

16. Substrat en céramique, composé d'une pile (2a) de couches (3, 3a) superposées qui contiennent une matière céramique et qui sont frittées entre elles et qui contiennent les restes inaltérés d'un adjuvant (5) de frittage, dans lequel une couche (3a) contient une proportion plus grande d'adjuvant (5) de frittage inaltéré que la couche (3) voisine,
dans lequel il y a entre la couche (3) ayant la proportion accrue d'adjuvant (5) de frittage inaltéré et la couche (3) voisine de cette couche (3a), une couche (9) de réaction, qui contient l'adjuvant (5) de frittage de la couche (3a) et la matière céramique de la couche (3) qui en est voisine,
dans lequel la couche (9) de réaction facilite l'adhérence entre les couches (3, 3a) en céramique.

17. Substrat en céramique selon la revendication 16,
dans lequel la proportion accrue d'adjuvant (5) de frittage inaltéré est comprise entre 5 et 30 % en poids.

18. Substrat en céramique selon l'une des revendications 16 ou 17, dans lequel la couche (7) la plus haute de la pile (2a) de couches contient une proportion d'adjuvant (5) de filtrage inaltéré plus grande que la couche (3) voisine.

19. Substrat en céramique selon l'une des revendications 16 à 18, dans lequel l'épaisseur (d) de la couche (9) de réaction est comprise entre 10 et 50 µm.

20. Substrat en céramique selon l'une des revendications 18 ou 19, dans lequel une pâte (20) métallique est cuite sur la couche (7) la plus haute de la pile (2a).

21. Substrat en céramique selon l'une des revendications 16 à 20, dans lequel des pistes (10) conductrices sont disposées entre deux couches (3) de la pile (2a).

22. Substrat en céramique selon la revendication 21, dans lequel une couche (3) contient une traversée (11) conductrice de l'électricité, qui relie entre elles des pistes (10) conductrices disposées sur des faces différentes de la couche (3).
